# FASCICULE DE BREVET EUROPEEN

(11) **EP 1 153 000 B1**
(45) Date de publication et mention de la délivrance du brevet: **22.10.2003**
(21) Numéro de dépôt: 00985317.7
(22) Date de dépôt: 24.11.2000
(51) Int. Cl.: C04B 35/83, C04B 35/80, C30B 15/12, C23C 16/04

(54) **PROCEDE DE FABRICATION D'UN BOL EN MATERIAU COMPOSITE THERMOSTRUCTURAL, NOTAMMENT POUR UNE INSTALLATION DE PRODUCTION DE SILICIUM MONOCRISTALLIN**
VERFAHREN ZUR HERSTELLUNG EINER SCHALE AUS THERMOBESTÄNDIGEM VERBUNDWERKSTOFF, INSBESONDERE FÜR EINE EINRICHTUNG ZUR PRODUKTION VON EINKRISTALLINEM SILIZIUM
METHOD FOR MAKING A BOWL IN THERMOSTRUCTURAL COMPOSITE MATERIAL IN PARTICULAR FOR A MONOCRYSTALLINE SILICON PRODUCING INSTALLATION

(30) Priorité: 24.11.1999 FR 9914766
(43) Date de publication de la demande: 14.11.2001
(73) Titulaire: SNECMA MOTEURS, 75015 Paris (FR)
(72) Inventeur: GEORGES, Jean-Michel, F-33290 Blanquefort (FR); BENETHUILIERE, Daniel, F-33160 Saint Médard en Jalles (FR); PHILIPPE, Eric, F-33700 Mérignac (FR)
(74) Mandataire: Joly, Jean-Jacques
(86) Numéro de dépôt international: FR0003275
(87) Numéro de publication internationale: WO01038255

(56) Documents cités:
- US-A- 5 904 957

## Description

### Domaine de l'invention

L'invention concerne la fabrication de bols en matériau composite thermostructural. Un domaine d'application de l'invention est plus particulièrement la fabrication de bols destinés à recevoir des creusets contenant du métal fondu, tel que du silicium.

Par matériau composite thermostructural, on entend un matériau comprenant un renfort fibreux en fibres réfractaires, par exemple en fibres de carbone ou de céramique, densifié par une matrice réfractaire, par exemple en carbone ou en céramique. Les matériaux composites carbone/carbone (C/C) et les matériaux composites à matrice céramique (CMC) sont des exemples de matériaux composites thermostructuraux.

### Arrière-plan de l'invention

Un procédé bien connu de production de silicium monocristallin, destiné plus particulièrement à la fabrication de produits semi-conducteurs, consiste à faire fondre du silicium dans un creuset, à mettre en contact avec le bain de silicium liquide un germe de cristal ayant l'arrangement cristallin désiré, pour initier la solidification à partir du silicium contenu dans le creuset, avec l'arrangement cristallin voulu, et à tirer mécaniquement hors du creuset un lingot de silicium monocristallin ainsi obtenu. Ce procédé est connu sous l'appellation procédé Czochralski, ou procédé "CZ".

Le creuset contenant le silicium fondu est habituellement en quartz (SiO₂). Le creuset est placé-dans un bol qui est généralement en graphite, étant noté qu'il a été aussi proposé de le réaliser au moins partiellement en matériau composite C/C. Le bol repose par son fond sur un support. A cet effet, le fond du bol doit être usiné, notamment pour former une portée de centrage et une zone d'appui. En outre, dans l'application considérée, les impératifs de très haute pureté impliquent de faire appel à des matières premières pures, à des procédés non polluants et à des procédés de purification à l'état final ou à un état intermédiaire de fabrication du bol. Pour les produits carbonés (tels que graphite ou composites C/C), des procédés de purification par traitement à haute température (plus de 2000°C) sous atmosphère neutre ou réactive (par exemple halogène) sont connus et utilisés de façon courante.

Les pièces en graphite utilisées comme bols sont fragiles. Elles sont souvent réalisées en plusieurs parties (architecture en "pétales") et ne peuvent retenir le silicium fondu en cas de fuite du creuset. Ce problème de sécurité devient de plus en plus critique avec l'augmentation de taille des lingots de silicium tirés, donc l'accroissement de la masse de silicium liquide. Par ailleurs, les bols en graphite ont généralement une faible durée de vie et une épaisseur, donc aussi un encombrement important. L'utilisation de pièces en matériau composite C/C, qui ne présentent pas ces inconvénients et présentent en particulier de meilleures propriétés mécaniques, est préférable.

La fabrication d'une pièce en matériau composite C/C ou plus généralement en matériau composite thermostructural, comprend habituellement la réalisation d'une préforme fibreuse ayant une forme correspondant à celle de la pièce à réaliser et constituant le renfort fibreux du matériau composite, et la densification de la préforme par la matrice.

Des techniques couramment utilisées pour réaliser des préformes sont le bobinage filamentaire consistant à enrouler des fils sur un mandrin ayant une forme correspondant à celle de la préforme à réaliser, le drapage consistant à superposer des couches ou strates de texture fibreuse bidimensionnelle sur une forme adaptée à la forme de la préforme à réaliser, les strates superposées étant éventuellement liées entre elles par aiguilletage ou par couture, et encore le tissage ou tricotage tridimensionnel.

La densification de la préforme peut être réalisée de façon bien connue par voie liquide ou par voie gazeuse. La densification par voie liquide consiste à imprégner la préforme - ou à pré-imprégner les filaments ou strates qui la constituent - par un précurseur de la matrice, par exemple une résine précurseur de carbone ou de céramique, et à transformer le précurseur par traitement thermique. La densification par voie gazeuse, ou infiltration chimique en phase vapeur, consiste à placer la préforme dans une enceinte et à admettre dans l'enceinte une phase gazeuse précurseur de la matrice. Les conditions notamment de température et de pression sont ajustées pour permettre à la phase gazeuse de diffuser au sein de la porosité de la préforme et, au contact des fibres, de former sur celles-ci un dépôt du matériau constitutif de la matrice par décomposition d'un constituant de la phase gazeuse ou réaction entre plusieurs constituants.

Dans le cas de pièces ayant une forme relativement complexe, telle que celle d'un bol, une difficulté particulière réside dans la fabrication d'une préforme fibreuse ayant la forme correspondante.

Une autre difficulté réside dans l'obtention d'une densification raisonnablement simple et rapide, notamment dans le cas de bols de grandes dimensions. Or, pour l'industrie des semi-conducteurs, il existe un besoin de lingots de silicium de diamètres de plus en plus grands, ce qui impose la fourniture de creusets et bols de support de dimensions adaptées.

### Objet et résumé de l'invention

L'invention a pour but de proposer un procédé de fabrication d'un bol en matériau composite thermostructural qui permette de surmonter ces difficultés, tout en restant simple et économique.

Conformément à l'invention, le procédé comprend les étapes qui consistent à :
- réaliser par bobinage filamentaire une préforme de bol présentant un passage axial au niveau du fond,
- densifier la préforme de bol par infiltration chimique en phase vapeur, et
- obturer le passage par un bouchon.

La réalisation d'une préforme de bol présentant un passage axial présente deux avantages. D'une part, la préforme peut être réalisée par bobinage filamentaire sans difficultés excessives. Il en serait autrement si une préforme de bol complète devait être obtenue par bobinage filamentaire. D'autre part, lors de la densification de la préforme par infiltration chimique en phase vapeur, la présence d'un trou axial favorise l'écoulement de la phase gazeuse et par là-même, la densification.

De préférence, on réalise une préforme de bol rigidifiée ou consolidée, avant la densification par infiltration chimique en phase vapeur. De façon en soi connue, une préforme de bol consolidée est réalisée par densification partielle d'une structure fibreuse ayant la forme désirée, la densification partielle étant au moins suffisante pour donner à la préforme une tenue lui permettant d'être manipulée. La densification partielle peut être réalisée par voie liquide, avec imprégnation par un précurseur du matériau constitutif de la matrice du matériau composite et transformation du précurseur par traitement thermique, ou par voie gazeuse.

La préforme peut être consolidée par imprégnation par un précurseur de carbone, par exemple choisi parmi les résines phénoliques, furaniques, époxy et polyimides, et transformation du précurseur.

La réalisation de la préforme consolidée comprend avantageusement la réalisation d'un bobinage au moyen d'un fil imprégné par ledit précurseur.

Deux préformes consolidées peuvent être réalisées simultanément sur un mandrin ayant une forme correspondant à celle de deux parties de bol en regard, en réalisant le bobinage filamentaire sur le mandrin, et en tronçonnant le bobinage réalisé, dans sa partie médiane.

La densification de la préforme par infiltration chimique en phase vapeur permet d'obtenir une matrice de carbone qui présente la continuité nécessaire pour éviter une pollution de l'installation de production de silicium monocristallin par des particules issues des fibres ou d'un coke de résine formé sur les fibres pour consolider la préforme. Une matrice de carbone obtenue par infiltration chimique en phase vapeur présente aussi une meilleure tenue à la corrosion au contact du creuset en quartz à température élevée.

Avantageusement, la préforme de bol consolidée est réalisée à partir de fil exempt de traitement de surface, tel que, par exemple, une oxydation ménagée par voie électrochimique ou autre. Le fil est notamment un fil en carbone. L'absence de traitement de surface, généralement prévu sur les fils du commerce pour apporter des fonctions de surface favorisant la liaison avec les matrices organiques, contribue à une meilleure stabilité dimensionnelle en évitant l'apparition de contraintes internes lors de l'élaboration du matériau composite.

Selon une autre particularité du procédé, il comporte une étape consistant à réaliser une étape finale d'infiltration chimique en phase vapeur après obturation du passage par le bouchon, celui-ci étant de préférence en matériau composite thermostructural. L'étape finale d'infiltration peut comprendre la formation d'une phase de matrice de nature différente de celle précédemment formée lors des étapes de consolidation de la préforme de bol et de densification subséquente. Ainsi, dans le cas d'une préforme densifiée par du carbone, l'étape finale d'infiltration peut consister à déposer une phase de matrice céramique, par exemple en carbure de silicium. Une telle phase externe de matrice apporte un protection du matériau composite vis-à-vis de l'oxydation.

Avantageusement, le bol est soumis à un traitement de purification et stabilisation à haute température, de préférence à une température supérieure à 2200°C. La purification peut être réalisée sous atmosphère de chlore, comme cela est bien connu pour le graphite. Elle permet d'évacuer des impuretés susceptibles de polluer le silicium dans le cas de l'utilisation du bol comme support de creusets contenant du silicium pour fabriquer des lingots de silicium monocristallin.

Un tel traitement de purification pourrait être réalisé au stade de la préforme de bol consolidée. Le traitement thermique contribue alors en outre à éviter des variations dimensionnelles lors de la suite du processus de fabrication. Dans la mesure où le bouchon d'obturation du fond du bol aura subi également un traitement de purification, la réalisation d'une purification après infiltration chimique en phase vapeur pourrait alors ne pas être nécessaire.

Un revêtement de protection pourra être formé au moins du côté intérieur du bol. Un tel revêtement peut être en carbone pyrolytique, ou pyrocarbone, obtenu par dépôt chimique en phase vapeur, ou en céramique, par exemple carbure de silicium (SiC) obtenu également par infiltration chimique en phase vapeur. On pourra en variante munir la face intérieure du bol d'une couche de protection, par exemple en composite C/C.

### Brève description des dessins

L'invention sera mieux comprise à la description plus détaillée faite ci-après en référence aux dessins annexés sur lesquels :
- la figure 1 est une demi-vue en coupe très schématique montrant un bol en matériau composite utilisé comme support de creuset dans une installation de production de lingots de silicium ;
- la figure 2 est un diagramme montrant des étapes successives d'un premier mode de mise en oeuvre d'un procédé conforme à l'invention ; et
- les figures 3A à 3D sont des demi-vues en coupe qui montrent les étapes successives de réalisation d'un bol en matériau composite selon le procédé de la figure 2.

### Description détaillée de modes de réalisation

Comme déjà indiqué, le domaine d'application de l'invention est plus particulièrement la réalisation de bols en matériau composite thermostructural pour le support de creusets dans des installations de production de lingots de silicium monocristallin.

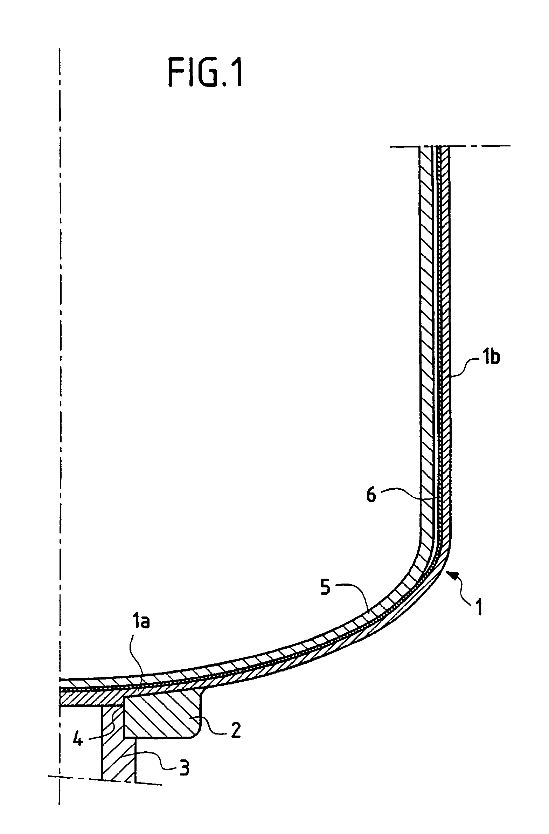

La figure 1 montre très schématiquement un tel bol en matériau composite, par exemple en matériau composite C/C, qui supporte un creuset 5, généralement en quartz. Le bol 1 repose sur un support annulaire formé par une bague 2 montée à l'extrémité d'un arbre 3 en formant avec celui-ci un décrochement 4. Le bol a une partie de fond 1a et une partie de pourtour 1b ayant une portion sensiblement cylindrique qui se raccorde à la partie de fond par une portion à profil arrondi. La partie de fond du bol 1 est usinée pour former une portée de centrage correspondant au décrochement 4 et une surface d'appui sur la bague 2.

Après remplissage du creuset par du silicium, l'ensemble est placé dans un four et la température dans le four est portée à une valeur suffisante pour provoquer la liquéfaction du silicium. A cette température, le creuset se ramollit et épouse la forme du bol. Un germe présentant l'arrangement cristallin désiré est ensuite amené au contact du bain de silicium puis extrait lentement en formant une colonne entre le germe et le bain. Un lingot est ainsi tiré à faible vitesse, jusqu'à une longueur pouvant être de 1 à 2 m.

Ce procédé de fabrication de lingots de silicium est bien connu et ne fait pas partie de l'invention, de sorte qu'une description plus détaillée n'est pas nécessaire.

Par leur capacité à conserver des bonnes propriétés mécaniques et une bonne stabilité dimensionnelle aux températures élevées, les matériaux composites thermostructuraux conviennent particulièrement pour la réalisation de bols destinés à cette application.

Dans la description qui suit, on envisage la réalisation de bols en matériaux composites C/C à renfort fibreux en fibres de carbone et matrice en carbone ou au moins essentiellement en carbone . L'invention englobe aussi la réalisation de bols en matériaux composite de type CMC, à renfort fibreux en fibres en céramique (par exemple en fibres SiC) et à matrice également céramique (par exemple également en SiC), les technologies d'élaboration des CMC étant bien connues.

Le renfort fibreux est réalisé à partir de fils tels que disponibles dans le commerce mais exempts de traitement de surface habituellement prévu pour apporter des fonctions de surface favorisant la liaison avec une matrice organique lorsque ces fils sont utilisés pour former des matériaux composites de type fibres/résine non destinés à des applications à des températures élevées. L'absence de fonctions de surface permet d'éviter des contraintes internes lors du processus de fabrication du matériau composite avec le procédé de l'invention.

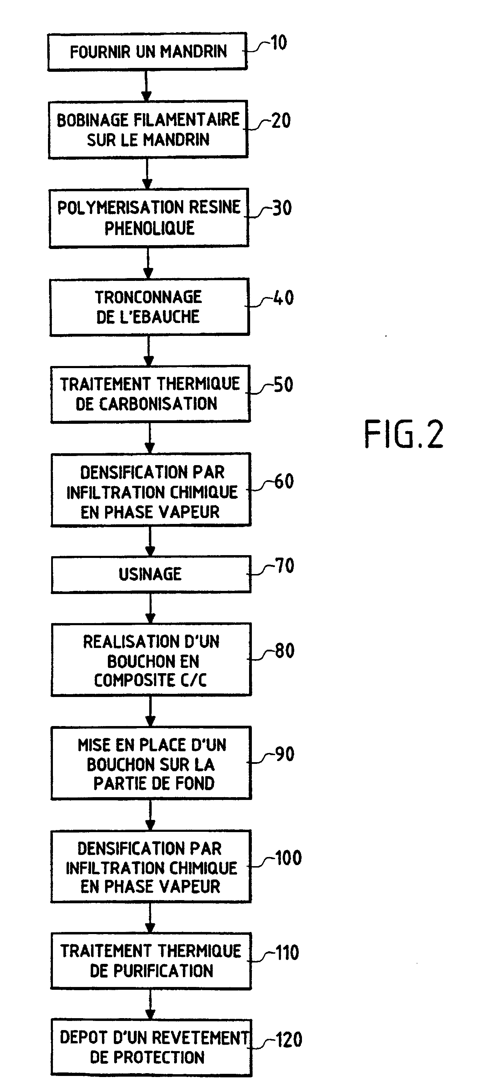

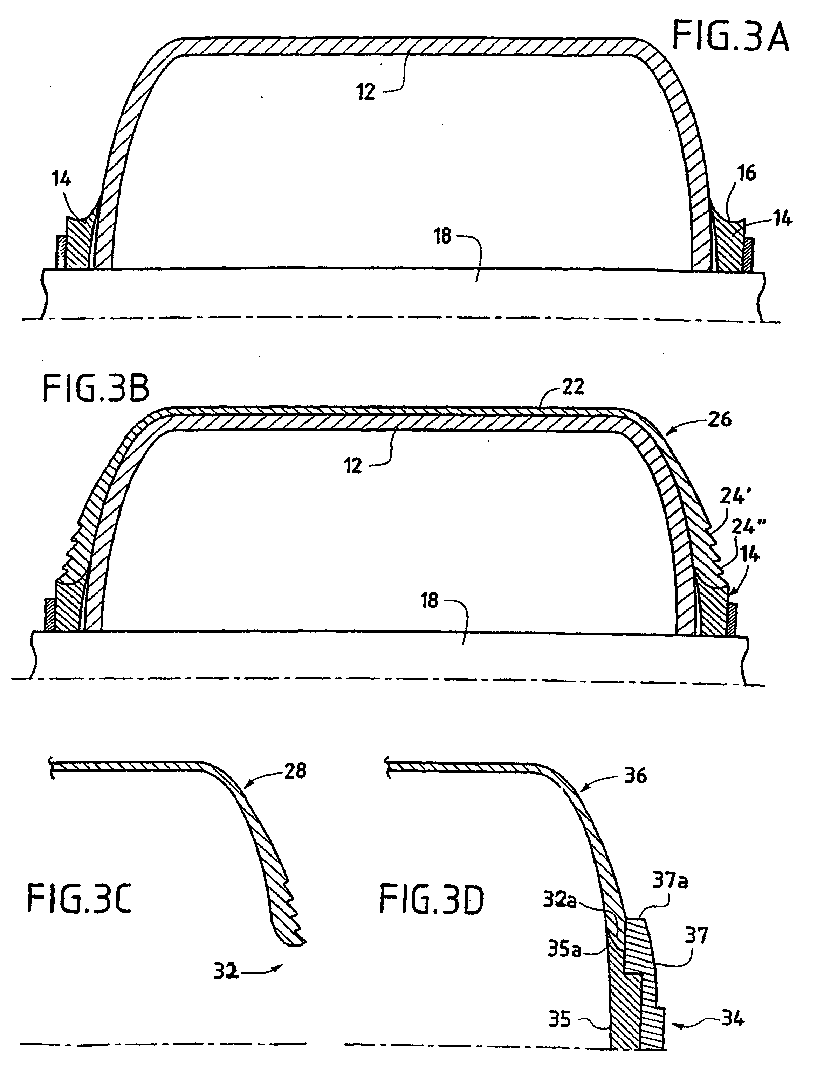

Un premier mode de mise en oeuvre d'un procédé de fabrication de bol en matériau composite sera maintenant décrit en référence aux figures 2 et 3A à 3D.

Une première étape 10 du procédé (figure 2) consiste à fournir un mandrin 12 (figure 3A). Celui-ci a une forme correspondant à celle de deux parties de pourtour de bols à réaliser placés tête-bêche. A ses extrémités axiales, le mandrin est complété par des bagues 14 qui présentent un évidement annulaire 16 formé dans leur surface extérieure, à leur périphérie.

Le mandrin 12 et les bagues 14 sont par exemple métalliques. L'ensemble est monté et immobilisé axialement sur un axe 18 qui passe à travers des passages centraux des bagues 14 et est relié à un moteur d'entraînement en rotation (non représenté).

Une deuxième étape 20 du procédé consiste à réaliser un bobinage filamentaire sur le mandrin 12.

Le bobinage 22 est réalisé au moyen d'un fil pré-imprégné par un précurseur liquide du carbone, par exemple une résine phénolique. Aux extrémités axiales du mandrin, le bobinage s'étend jusqu'à réaliser un bobinage partiel des bagues 14 au niveau des évidements 16. Le bobinage est poursuivi jusqu'à atteindre l'épaisseur désirée pour les préformes correspondant aux parties de pourtours de bols situées tête-bêche (figure 3B). Les bagues 14 facilitent l'arrêt du bobinage filamentaire aux extrémités axiales de celui-ci. Les bagues 14 pourraient être réalisées d'une seule pièce avec le mandrin 12. Pour éviter une trop grande épaisseur de bobinage au niveau des zones d'extrémité du mandrin où le diamètre décroît relativement fortement, le bobinage peut comporter plusieurs chignons 24', 24", .... étagés sur des diamètres différents.

Après bobinage, l'ébauche 26 formée par le bobinage 22, et supportée par le mandrin 12, est placée en étuve pour réaliser la polymérisation de la résine phénolique imprégnant le fil de bobinage (étape 30 du procédé).

A l'étage suivante 40, l'ébauche 26 est tronçonnée radialement en son milieu pour obtenir deux demi-coques 28 qui sont retirées du mandrin 12 (figure 3C), chacune présentant un passage axial 32.

Chaque demi-coque 28 est alors traitée thermiquement (étape 50) pour réaliser une carbonisation de la résine phénolique et obtenir une préforme de bol consolidée comprenant un passage axial 32 au niveau du fond. La consolidation du bobinage filamentaire consiste en une densification par la matrice carbone issue de la transformation de la résine phénolique. On obtient une préforme partiellement densifiée, c'est-à-dire présentant une porosité résiduelle accessible, tout en ayant une tenue suffisante pour être manipulée.

Ensuite, la préforme de bol purifiée est placée dans une enceinte pour subir une étape de densification chimique en phase de vapeur (étape 60 du procédé). La densification est réalisée pour combler au moins partiellement la porosité résiduelle de la préforme consolidée par du carbone pyrolytique. Celui-ci est obtenu de façon bien connue en soi à partir d'une phase gazeuse contenant un hydrocarbure, tel que du méthane ou gaz naturel, constituant le précurseur du carbone.

Plusieurs préformes de bol peuvent être densifiées simultanément à l'intérieur d'une même enceinte. A cet effet, les préformes sont disposées les unes au-dessus des autres, en étant alignées axialement et en ménageant entre elles des intervalles dans lesquels la phase gazeuse peut circuler. Un procédé d'infiltration chimique en phase vapeur avec flux dirigé de la phase gazeuse, tel que décrit dans le brevet US 5 904 957, peut être utilisé.

L'étape 60 d'infiltration chimique en phase vapeur contribue non seulement à compléter la densification de la préforme, mais aussi à former une matrice continue ayant une microstructure contrôlée et capable de bloquer au sein du matériau d'éventuelles particules de carbone des fibres ou grains de coke de résine de consolidation, de sorte qu'une pollution éventuelle par ces particules ou grains lors de l'utilisation du bol est évitée. Par rapport à une matrice carbone obtenue par voie liquide, la matrice carbone obtenue par infiltration chimique en phase vapeur présente en outre une meilleure tenue à la corrosion au contact d'un creuset en quartz à température élevée.

L'étape suivante 70 du procédé consiste à réaliser un usinage dans la partie de fond du bol afin d'y fixer un bouchon 34 pour obturer le passage 32 (figure 3D). Dans l'exemple illustré, le bouchon 34 est réalisé en deux pièces 35, 37 par exemple en matériau composite C/C (étape 80), ayant subi si nécessaire une étape de purification du carbone. La pièce 35 a une forme de coupelle ayant un pourtour en forme de lèvre 35a s'appuyant sur le rebord du passage 32, du côté intérieur du bol tandis que la pièce 37, également en forme de coupelle a un rebord 37a s'appuyant sur le rebord du passage 32 du côté extérieur. La liaison entre les pièces 35 et 37 peut être réalisée par vissage, la pièce 35 présentant une partie centrale en saillie qui est vissée dans un logement de la pièce 37. Les pièces 35 et 37 enserrent le rebord 32a de l'ouverture 32. Les pièces 35 et 37 constitutives du 34 en matériau composite C/C peuvent être réalisées par tout procédé connu. Par exemple, des préformes sont formées par superposition de strates bidimensionnelles en forme de disques en fibres de carbone. Les strates, par exemple en tissu, sont liées entre elles par aiguilletage ou par couture. Une densification par une matrice en carbone est ensuite réalisée par une voie liquide ou par infiltration chimique en phase vapeur.

Après montage du bouchon 34 (étape 90), une nouvelle étape finale 100 de densification d'une phase finale de matrice en carbone obtenue par infiltration chimique en phase vapeur peut être réalisée afin de parfaire l'assemblage du bouchon 34 avec la partie de fond de la préforme 28 et compléter la densification de cette dernière. Un bol 36 en matériau composite C/C est alors obtenu prêt à être utilisé, éventuellement après un usinage final de finition de la partie de fond et du bouchon 34.

L'étape suivante 110 du procédé consiste à réaliser une purification du carbone du bol obtenu lorsque, pour l'application envisagée, le bol à réaliser doit être exempt d'impuretés. Il en est ainsi pour des installations de tirage de silicium monocristallin destiné à la fabrication de produits semi-conducteurs, le silicium devant être initialement non contaminé par des impuretés. La purification du carbone peut être obtenue par traitement thermique à une température comprise de préférence entre 2200°C et 3000°C, par exemple égale à environ 2400°C, sous une atmosphère non oxydante, par exemple sous une atmosphère de chlore, et à une pression de préférence inférieure à 100 kPa, par exemple égale à environ 10 kPa. Un tel traitement thermique sous chlore est bien connu en soi pour la purification du graphite. Ce traitement thermique réalise aussi une stabilisation dimensionnelle de la préforme de bol consolidée. En variante, la purification pourrait être réalisée au stade de la préforme de bol consolidée, après l'étape 50. Dans la mesure où le bouchon 34 aura aussi subi une purification, l'étape finale de purification, après infiltration chimique en phase vapeur, pourra être omise.

Dans le cas où le bol est destiné à recevoir un creuset en quartz, il peut être souhaitable de protéger le bol vis-à-vis d'une érosion provoquée par une réaction chimique entre le quartz (SiO₂) et le carbone du bol à la température d'utilisation du creuset. Dans le cas de tirage de silicium monocristallin, le creuset est en effet porté à une température d'environ 1600°C à laquelle le quartz se ramollit, flue en épousant la forme de bol de support, et a tendance à être réactif.

Une protection peut être obtenue en formant au moins du côté intérieur du bol un revêtement de protection (étape 120). Le revêtement de protection peut être en carbone pyrolytique, ou pyrocarbone, obtenu par dépôt chimique en phase vapeur, ou en céramique, par exemple carbure de silicium (SiC), obtenu également par infiltration en phase vapeur. De façon bien connue en soi, un dépôt SiC peut être obtenu par dépôt chimique en phase vapeur à partir d'une phase gazeuse contenant un précurseur de SiC tel que le MTS (méthyltrichlorosilane).

Le revêtement de protection peut être formé dans la continuité de l'étape finale 100 de densification, avant le traitement thermique final éventuel de purification.

En variante, une protection du bol peut être réalisée en interposant entre le bol et le creuset une couche intercalaire épousant la forme du bol, par exemple une couche de protection en composite thermostructural tel qu'un composite C/C obtenu par densification d'une préforme fibreuse formée de feutre de carbone ou de strates bidimensionnelles en fibres de carbone.

La figure 1 montre une telle couche de protection 6 garnissant la face intérieure du bol 1. Cette couche de protection est consommable, un re-garnissage du bol étant effectué périodiquement.

Bien que l'on ait envisagé ci-avant le bobinage d'une ébauche permettant de réaliser simultanément deux ébauches de bol, il va de soi que les ébauches de bol pourront être fabriquées individuellement.

## Revendications

1. Procédé de fabrication d'un bol en matériau composite thermostructural formé d'un renfort fibreux densifié par une matrice, **caractérisé en ce qu'**il comprend les étapes qui consistent à :
- réaliser par bobinage filamentaire une préforme de bol (28) présentant un passage axial (32) au niveau du fond,
- densifier la préforme de bol par infiltration chimique en phase vapeur, et
- obturer le passage par un bouchon (34).

2. Procédé selon la revendication 1, **caractérisé en ce que** l'on réalise une préforme de bol consolidée avant infiltration chimique en phase vapeur.

3. Procédé selon l'une quelconque des revendications 1 et 2, **caractérisé en ce que** la préforme de bol (28) consolidée est réalisée par bobinage d'un fil imprégné par un précurseur dudit matériau constitutif de la matrice et transformation du précurseur par traitement thermique.

4. Procédé selon la revendication 3, **caractérisé en ce que** la préforme de bol (28) consolidée est réalisée par bobinage d'un fil imprégné par un précurseur de carbone et transformation du précurseur.

5. Procédé selon la revendication 4, **caractérisé en ce que** le précurseur de carbone est choisi parmi les résines phénoliques, furaniques, époxy et polyimides.

6. Procédé selon l'une quelconque des revendications 3, 4 et 5, **caractérisé en ce que** l'on réalise simultanément deux préformes consolidées, en réalisant le bobinage sur un mandrin (12) ayant une forme correspondant à celle de deux parties de pourtour de bol tête-bêche, et en tronçonnant le bobinage réalisé (22), dans sa partie médiane.

7. Procédé selon l'une quelconque des revendications 1 à 6, **caractérisé en ce que** la préforme de bol est réalisée à partir de fil exempt de traitement de surface apportant des fonctions de surface.

8. Procédé selon l'une quelconque des revendications 1 à 7, **caractérisé en ce que** la préforme de bol est réalisée à partir de fil en carbone.

9. Procédé selon l'une quelconque des revendications 1 à 8, **caractérisé en ce que** le bol est soumis à un traitement de purification et stabilisation à haute température.

10. Procédé selon l'une quelconque des revendications 1 à 8, **caractérisé en ce qu'**un traitement de purification et stabilisation à haute température est réalisé à un stade de préforme de bol consolidée.

11. Procédé selon l'une quelconque des revendications 9 et 10, **caractérisé en ce que** le traitement de purification et stabilisation est réalisé à une température supérieure à 2200°C.

12. Procédé selon l'une quelconque des revendications 1 à 11, **caractérisé en ce que** la densification de la préforme de bol est réalisée par formation d'une matrice en carbone.

13. Procédé selon l'une quelconque des revendications 1 à 12, **caractérisé en ce que** le bouchon (34) est réalisé en deux parties (35,37) assemblées l'une à l'autre en enserrant le rebord du passage axial de la préforme.

14. Procédé selon l'une quelconque des revendications 1 à 13, **caractérisé en ce que** le passage (32) est obturé par un bouchon (34) en matériau composite thermostructural.

15. Procédé selon l'une quelconque des revendications 1 à 14, **caractérisé en ce qu'**il comporte une étape consistant à réaliser une étape finale d'infiltration chimique en phase vapeur après obturation du passage (32) par le bouchon (34).

16. Procédé selon la revendication 15, **caractérisé en ce que** l'étape finale d'infiltration chimique en phase vapeur comprend la formation d'une phase de matrice céramique.

17. Procédé selon la revendication 16, **caractérisé en ce que** la phase de matrice céramique est en carbure de silicium.

18. Procédé selon l'une quelconque des revendications 1 à 17, **caractérisé en ce que** l'on forme un revêtement de protection au moins sur la face intérieure du bol.

19. Procédé selon la revendication 18, **caractérisé en ce que** l'on forme un revêtement de protection en pyrocarbone.

20. Procédé selon la revendication 18, **caractérisé en ce que** l'on forme un revêtement de protection en carbure de silicium.

21. Procédé selon l'une quelconque des revendications 1 à 20, **caractérisé en ce que** l'on munit la face intérieure du bol d'une couche de protection.

22. Procédé selon la revendication 21, **caractérisé en ce que** la couche de protection est en matériau composite thermostructural.

23. Procédé selon la revendication 22, **caractérisé en ce que** plusieurs préformes de bol consolidées sont densifiées simultanément par infiltration chimique en phase vapeur.

## Patentansprüche

1. Verfahren zur Herstellung einer Schüssel aus bei erhöhter Temperatur belastbarem Verbundmaterial, welches aus einer Faserverstärkung gebildet wird, die in einer Matrix verdichtet wird, **dadurch gekennzeichnet, daß** es Schritte aufweist, die bestehen aus:
- Erzeugen einer Vorform (28) der Schüssel mit einer axialen Öffnung (32) am Boden durch Faserwickeln;
- Verdichten der Vorform durch chemische Infiltration in der Dampfphase; und
- Verschließen der Öffnung durch einen Stopfen (34).

2. Verfahren nach Anspruch 1, **dadurch gekennzeichnet, daß** eine verfestigte Vorform der Schüssel vor der chemischen Infiltration in der Dampfphase erzeugt wird.

3. Verfahren nach einem der Ansprüche 1 und 2, **dadurch gekennzeichnet, daß** die verfestigte Vorform der Schüssel (28) erzeugt wird durch Wickeln mit einer Faser, die mit einer Vorstufe desjenigen Materials imprägniert ist, welches die Matrix bilden soll, und durch Umwandlung der Vorstufe durch thermische Behandlung.

4. Verfahren nach Anspruch 3, **dadurch gekennzeichnet, daß** die verfestigte Vorform der Schüssel (28) erzeugt wird durch Wickeln mit einer Faser, die mit einer Vorstufe von Kohlenstoff imprägniert ist, und Umwandlung der Vorstufe.

5. Verfahren nach Anspruch 4, **dadurch gekennzeichnet, daß** die Vorstufe von Kohlenstoff ausgewählt wird aus den Phenolharzen, Furanharzen, Epoxidharzen und Polyimidharzen.

6. Verfahren nach einem der Ansprüche 3, 4 und 5, **dadurch gekennzeichnet, daß** gleichzeitig zwei verfestigte Vorformen durch Wickeln auf einem Wikkeldorn (12) erzeugt werden, der eine Form besitzt, die derjenigen zweier entgegengesetzter Schalenumfangspartien entspricht, und daß die erzeugte Wicklung in ihrem mittleren Abschnitt durchtrennt wird.

7. Verfahren nach einem der Ansprüche 1 bis 6, **dadurch gekennzeichnet, daß** die Vorform der Schale aus Fasern erzeugt wird, die frei von Oberflächenbehandlung, welche Oberflächeneigenschaften mit sich bringt, sind.

8. Verfahren nach einem der Ansprüche 1 bis 7, **dadurch gekennzeichnet, daß** die Vorform der Schale aus Kohlenstofffasern erzeugt wird.

9. Verfahren nach einem der Ansprüche 1 bis 8, **dadurch gekennzeichnet, daß** die Schale einer Behandlung zur Reinigung und Stabilisierung bei hoher Temperatur unterzogen wird.

10. Verfahren nach einem der Ansprüche 1 bis 8, **dadurch gekennzeichnet, daß** eine Behandlung zur Reinigung und Stabilisierung bei hoher Temperatur in einem Stadium der verfestigten Vorform der Schale durchgeführt wird.

11. Verfahren nach einem der Ansprüche 9 und 10, **dadurch gekennzeichnet, daß** die Behandlung zur Reinigung und Stabilisierung bei einer Temparatur von über 2200°C durchgeführt wird.

12. Verfahren nach einem der Ansprüche 1 bis 11, **dadurch gekennzeichnet, daß** die Verdichtung der Vorform der Schale durch Bildung einer Matrix aus Kohlenstoff durchgeführt wird.

13. Verfahren nach einem der Ansprüche 1 bis 12, **dadurch gekennzeichnet, daß** der Stopfen (34) aus zwei Teilen (35, 37) besteht, die miteinander zusammengesetzt den Rand der axialen Öffnung der Vorform einschließen.

14. Verfahren nach einem der Ansprüche 1 bis 13, **dadurch gekennzeichnet, daß** die Öffnung (32) durch einen Stopfen (34) aus bei erhöhter Temperatur belastbarem Verbundmaterial verschlossen wird.

15. Verfahren nach einem der Ansprüche 1 bis 14, **dadurch gekennzeichnet, daß** es einen Schritt aufweist, der aus einem abschließendem Schritt der chemischen Infiltration in der Dampfphase nach Verschließen der Öffnung (32) durch den Stopfen (34) besteht.

16. Verfahren nach Anspruch 15, **dadurch gekennzeichnet, daß** der abschließende Schritt der chemischen Infiltration in der Dampfphase die Bildung einer keramischen Matrixphase aufweist.

17. Verfahren nach Anspruch 16, **dadurch gekennzeichnet, daß** die keramische Matrixphase aus Siliziumkarbid ist.

18. Verfahren nach einem der Ansprüche 1 bis 17, **dadurch gekennzeichnet, daß** eine Schutzverkleidung mindestens auf der Innenseite der Schale gebildet wird.

19. Verfahren nach Anspruch 18, **dadurch gekennzeichnet, daß** eine Schutzverkleidung aus Pyrokohlenstoff gebildet wird.

20. Verfahren nach Anspruch 18, **dadurch gekennzeichnet, daß** eine Schutzverkleidung aus Siliziumkarbid gebildet wird.

21. Verfahren nach einem der Ansprüche 1 bis 20, **dadurch gekennzeichnet, daß** an der Innenseite der Schale eine Schutzschicht angebracht wird.

22. Verfahren nach Anspruch 21, **dadurch gekennzeichnet, daß** die Schutzschicht aus bei erhöhter Temperatur belastbarem Verbundmaterial besteht.

23. Verfahren nach einem der Ansprüche 1 bis 22, **dadurch gekennzeichnet, daß** mehrere Vorformen von Schalen gleichzeitig durch chemische Infiltration in der Dampfphase verdichtet werden.

## Claims

1. A method of manufacturing a bowl of thermostructural composite material formed by a fibre reinforcement densified by a matrix, the method being **characterised in that** it comprises the steps consisting in:
˙ making a bowl preform (28) by winding a yam, the preform having an axial passage (32) through its bottom;
˙ densifying the bowl preform by chemical vapour infiltration; and
˙ closing the passage by means of a plug (34).

2. A method according to claim 1, **characterised in that** a consolidated bowl preform is made prior to chemical vapour infiltration.

3. A method according to claim 1 or claim 2, **characterised in that** the consolidated bowl preform (28) is made by winding a yarn impregnated by a precursor for said material constituting the matrix, and by transforming the precursor by heat treatment.

4. A method according to claim 3, **characterised in that** the consolidated bowl preform (28) is made by winding a yarn impregnated by a carbon precursor and by transforming the precursor.

5. A method according to claim 4, **characterised in that** the carbon precursor is selected from phenolic, furan, epoxy, and polyimide resins.

6. A method according to any one of claims 3, 4 and 5, **characterised in that** two consolidated preforms are made simultaneously by winding a shape on a mandrel (12) where the shape corresponds to that two bowl outline portions joined rim-to-rim, and by cutting the resulting winding (22) in its middle portion.

7. A method according to any one of claims 1 to 6, **characterised in that** the bowl preform is made from yarn that has no surface treatment to provide surface functions.

8. A method according to any one of claims 1 to 7, **characterised in that** the bowl preform is made from a carbon yarn.

9. A method according to any one of claims 1 to 8, **characterised in that** the bowl is subjected to high temperature purification and stabilization treatment.

10. A method according to any one of claims 1 to 8, **characterised in that** the high temperature purification and stabilization treatment is performed at a stage of consolidated bowl preform.

11. A method according to claim 9 or claim 10, **characterised in that** the purification and stabilization treatment is performed at a temperature greater than 2200°C.

12. A method according to any one of claims 1 to 11, **characterised in that** bowl preform densification is performed by forming a carbon matrix.

13. A method according to any one of claims 1 to 12, **characterised in that** the plug (34) is made in two pieces (35, 37) that are assembled together so as to clamp onto the rim of the axial passage in the preform.

14. A method according to any one of claims 1 to 13, **characterised in that** the passage (32) is closed by a plug (34) made of thermostructural composite material.

15. A method according to any one of claims 1 to 14, **characterised in that** it includes a step consisting in performing a final chemical vapour infiltration step after the passage (32) has been closed by the plug (34).

16. A method according to claim 15, **characterised in that** the final chemical vapour infiltration step comprises forming a ceramic matrix phase.

17. A method according to claim 16, **characterised in that** the ceramic matrix phase is made of silicon carbide.

18. A method according to any one of claims 1 to 17, **characterised in that** a protective coating is made at least on the inside face of the bowl.

19. A method according to claim 18, **characterised in that** a protective coating is made out of pyrolytic carbon.

20. A method according to claim 18, **characterised in that** a protective coating is made out of silicon carbide.

21. A method according to any one of claims 1 to 20, **characterised in that** the inside face of the bowl is provided with a protective layer.

22. A method according to claim 21, **characterised in that** the protective layer is made of thermostructural composite material.

23. A method according to any one of claims 1 to 22, **characterised in that** a plurality of consolidated bowl preforms are densified simultaneously by chemical vapour infiltration.
